(19) Europäisches Patentamt
European Patent Office
Office européen des brevets

(11) **EP 4 484 034 A1**

(12) **EUROPEAN PATENT APPLICATION**

(43) Date of publication:
**01.01.2025 Bulletin 2025/01**

(21) Application number: **23382677.5**

(22) Date of filing: **30.06.2023**

(51) International Patent Classification (IPC):
**B22F 1/0545** (2022.01)   **B22F 1/102** (2022.01)
**B22F 3/23** (2006.01)   **C22C 1/04** (2023.01)
**C09D 11/52** (2014.01)   **C09D 11/54** (2014.01)
**H05K 1/09** (2006.01)   **H05K 3/12** (2006.01)
**B22F 7/04** (2006.01)

(52) Cooperative Patent Classification (CPC):
**B22F 1/0545; B22F 1/102; B22F 3/23;
C09D 11/322; C09D 11/52; C22C 1/0466;
C22C 5/02; H05K 1/097; H05K 3/125;**
B22F 2007/045

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicants:
• **Fundació Institut Català de Nanociència i
Nanotecnologia (ICN2)
08193 Bellaterra (ES)**
• **Institució Catalana De Recerca I
Estudis Avançats (ICREA)
08010 Barcelona (ES)**

(72) Inventors:
• **Merkoçi Hyka, Arben
Cerdanyola del Valles (ES)**
• **Urban, Massimo
Barcelona (ES)**
• **Rosati, Giulio
Cerdanyola del Valles (ES)**

(74) Representative: **Ponti & Partners, S.L.P
Edifici PRISMA
Av. Diagonal núm. 611-613, Planta 2
08028 Barcelona (ES)**

(54) **A SINTERING METHOD FOR OBTAINING NANOSTRUCTURED CONDUCTIVE NANOPARTICLE FILMS, NANOSTRUCTURED CONDUCTIVE NANOPARTICLE FILM OBTAINABLE THEREBY AND THEIR USES**

(57)   The present invention is directed to a novel sintering method for obtaining nanostructured conductive metal nanoparticle films on different substrates which is suitable for room-temperatures conditions.

The invention is also directed to a nanostructured conductive metal nanoparticle film obtainable by said sintering method, as well as their uses for electrochemical and/or photonic biosensing in, for example, flexible electronics.

**FIG 1**

a. AuNPs cartridge fill | Printing | NaBH₄ treatment | Devices ready for use

b. PVP — AuNP

c. AuNPs ink | NaBH₄ | Cartridge 1 | Cartridge 2 | Piezo-electric printhead | Nozzle 1 | Advancement direction | Nozzle 2 | Solvent evaporation | Substrate

EP 4 484 034 A1

**Description**

**Field of the invention**

The present invention is in the nanostructured conductive metallic materials field. In particular, the present invention relates to a novel sintering method capable of preparing nanostructured conductive metal nanoparticle films, suitable for inkjet printing nanostructured conductive metal nanoparticle films.

The present invention also relates to the obtainable nanostructured conductive nanoparticle film as well as to a device comprising the same and uses thereof.

**Background of the invention**

In the last decade, inkjet printing became a popular fabrication technique in the fields of flexible electronics and biosensing, taking advantage of nanofunctional inks, typically composed of metal nanoparticles (MNPs). Despite its flexibility, high throughput and low cost, one of the unresolved issues of this technique is the need for additional post-print treatments to make the printed patterns conductive. Such post-print treatments are sintering methods.

Typically, sintering is performed by thermal annealing, plasma treatments, or photonic and microwave irradiation. The choice is typically based on the type of printing substrate, or time-related requirements, e.g., in mass fabrication lines a photonic approach is usually preferred.

However, flexible electronics and biosensing, often based on plastic or paper substrates, find obvious issues regarding thermal annealing, due to the temperatures required for that.

Alternative chemical sintering strategies have been explored. However, these alternatives often are based on the use of chemical agents, such as gases, ionic compounds, and salts to induce the metal nanoparticles de-capping/sintering, particularly used for silver nanoparticle-based inks, and not suitable for scaling at industrial scale.

In this sense, WO2022157725 discloses a silver nano-ink composition comprising plurality of mixed-phase capped nanoparticles, at least one solvent and at least one excipient. The mixed-phase capped nanoparticle comprises of 5 to 95 vol. % silver phases, and of 5 to 95 vol. % silver oxide phases. The method for obtaining the silver nano-ink composition comprises act of mixing plurality of mixed-phase capped nanoparticle with at least one solvent and at least one excipient onto a substrate for forming a conductive silver pattern through thermal curing at a temperature ranging from 40°C - 150°C. The reaction needs chemically unstable metal nanoparticles to work. In fact, the silver nanoparticle undergoes redox reaction in the media triggered by partially oxidized particles and a chemical reducing agent. Energy is needed to initiate the process and the reduction of the oxide layer takes place all over the nanoparticle surface. Unfortunately, this does not allow control over the nano-structuration of the structure.

On the other hand, 2009 Coutts et al. reported the use of $NO_2$ gas for the sintering of printed films based on thiol-stabilized AuNPs. This procedure implies the use of $HNO_3$ and copper for the *in-situ* formation of the gas, and its use is limited to thiol-stabilized nanoparticles. Unfortunately, the proposed method, despite making the film conductive causes a nanostructure reduction, with the consequent reduction of the surface-to-volume ratio, in turn resulting in scarce electrochemical performances.

KR10-1481629 discloses a conductive metal nanoparticle ink and a method for preparing the same. The method uses vaporization energy of a sintering agent added to the ink, and the temperature sintering is about 150°C. The sintering agent can be sodium borohydride, although it does not react directly with the materials. The reaction occurs when the system is heated to about 150°C, necessary condition to dissociate the hydrogen producing reagent. This being the active species inducing the destabilization of the polymeric coating. The sintering occurs mainly thanks to the applied temperature.

Although this method uses temperatures of about 150°C, which are lower compared to most of the state of the art of 250°C - 600 °C, around 150°C are still temperatures too high for substrates possibles at the newly electronic industry.

As it is known in the art, traditional sintering methods require high temperatures, which for gold and platinum typically are greater than 250°C or require expensive light sources for the process to take place.

Therefore, there is still the need in the art for a method capable of sintering onto substrates of low melting point such as of plastic or paper nature.

Most of the methods of the art use either expensive equipment, or high temperatures, which hinder the possibility of using most of the flexible plastic/paper substrates for said new electronic applications.

Therefore, there is still the need to provide a method capable of making conductive nanoparticle film nanostructures, whose method be work at lower temperature conditions compared with the ones of the state of the art.

On the other hand, it is desirable to provide a sintering method that overcome one of the main drawbacks in the art, that is, where the typically porous, and not conductive, nanostructure defined by the deposited metal nanoparticles is sacrificed to obtain a conductive, and much less porous, surface.

Thus, the methods of the art, to one degree or another, present certain disadvantages and limitations, and there is still the need to provide nanostructured conductive materials, which are fundamental for numerous applications, and to provide metallic materials with enhanced nano-porosity, which is highly desirable in electrochemistry for applications related to, for example, healthcare, energy, and environmental and food quality monitoring.

It is still a need to provide a sintering method not requiring expensive equipment and be suitable for scalable at industrial level.

It is also desirable to provide a sintering method suitable for inkjet printing nanostructured and conductive metal nanoparticles films.

## Description of the invention

The present invention was made in view of the prior art described above, and the object of the present invention is, in a first aspect, to provide a novel sintering method capable of preparing nanostructured and conductive nanoparticle films in a rapid and an easily scalable method at industrial level.

To solve the problem, the present invention provides, in a first aspect, a sintering method, which is characterized in that sintering the nanoparticles and nano-structuration of the film is carried out in a single chemical reaction, at the same time.

Surprisingly, the authors of the present invention have found that the single chemical reaction is almost instantaneous and induces the sintering of the nanoparticles and at the same time the nano-structuration in the film.

Advantageously, the sintering method is carried out in few minutes and even in real-time, which allows it to be integrated into an inkjet printing method suitable for consumer printers.

Also advantageously, the sintering method in accordance with the first aspect is of easy application, saves energy, uses standard and available chemical reagents and inexpensive equipment, and is suitable for sintering and nanostructuring at room or ambient temperature.

Additionally, the sintering method in accordance with the first aspect of the present invention is also capable of changing the kinetics of the catalytic reaction of said single chemical reaction to finely modulating the conductivity and morphological properties of the nanostructured surfaces.

To that purpose, the concentrations of the reactants employed in the single chemical reaction are essential.

In a second aspect, the object of the present invention is a nanostructured conductive metal nanoparticle film, which is obtainable by the sintering method in accordance with the first aspect of the present invention.

Surprisingly, the nanostructured conductive metal nanoparticle film comprises the metal nanoparticles connected between them forming a conductive network structure with extended nano-structuration in the film.

The nanostructured conductive metal nanoparticle film has tunable conductivity and morphological properties.

In a third aspect, the object of the present invention is a device comprising the nanostructured conductive metal nanoparticle film in accordance with the second aspect of the present invention on a substrate, whose device is characterized in that the nanostructured conductive metal nanoparticle film defines a conductive pattern on the substrate, for example, in a flexible and/or low melting point temperatures substrate.

The device comprises tunable conductivity and morphological properties of the patterned nanostructured film. Thus, the device is suitable for several electrical, electrochemical and/or photoelectrical applications.

In still a further aspect, the present invention is directed to the use of said nanostructured conductive metal nanoparticle film and/or of said device for electrical, electrochemical and/or photoelectrical applications.

## Definitions

According to the present invention, the expression "room temperature" or "ambient temperature" means the same and encompasses any room or ambient temperature value comprised between 4°C and 45°C.

According to the present invention, the expression "low melting point temperature" in connection with a substrate means that the material of the substrate has a temperature melting point lower than 120°C.

## Brief Description of the Drawings

To better understand the description made, a set of drawings has been provided which, schematically and solely by way of non-limiting example, represents practical cases of various embodiments.

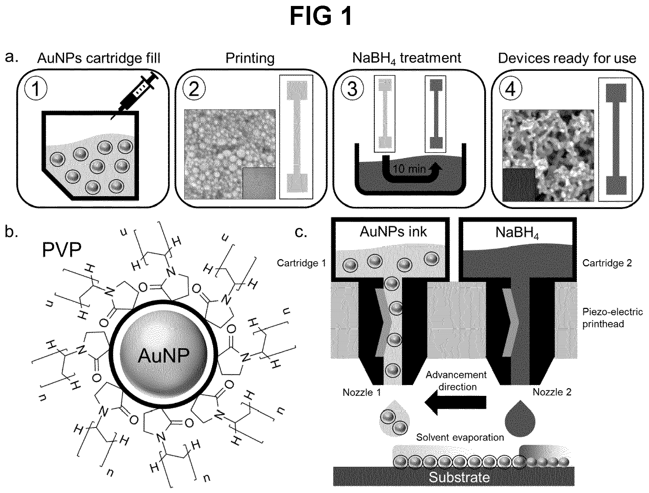

**Figure 1** depicts a general scheme of two embodiments of the invention, in which printing and sintering is performed by means of dipping (a: 1 to 4) using PVP caped gold nanoparticle (b) *versus* real-time integrated inkjet printing and sintering of gold nanoparticle films using a consumer printer (c).

**Figure 2** depicts SEM images (a-f) at different magnifications (g-l) 200 nm and (m-r) 50 nm of the sintered AuNPs-film treated with different concentrations of $NaBH_4$ in accordance with the examples.

**Figure 3** depicts a time-concentration SEM study of the morphological effects of the $NaBH_4$ treatment at different $NaBH_4$ concentrations for times spanning from 1 to 60 minutes.

**Figure 4** depicts an EDX spectra of the pristine (a-b) *versus* the AuNPs film treated with 1M of $NaBH_4$ (c-d). All the expected elements were found in the samples, with traces of the elements present in the plastic substrate used in the study for the printing (Al).

**Figure 5** depicts elemental maps and XPS survey of the AuNPs films treated with the different concentrations of $NaBH_4$ (a); pristine refers to the film not treated with the sintering agent. Compositional information of the gold peak for the different concentrations of the $NaBH_4$ used (b); the ratio and the atomic% of the main Au0 4f peak remain constant, even after increasing the concentration of NaBH4. The XPS measurements of the gold 4f5/2 and 4f7/2 peaks (c) showed a constant separation and the intensities do not appear to change proportionally with the $NaBH_4$ concentration.

**Figure 6** depicts enhanced Surface Raman Spectroscopy (SERS) using Rhodamine as a probe for the films treated with different concentrations of $NaBH_4$. Highlighted are the peaks characteristic of the rhodamine around 1600 cm$^{-1}$.

**Figure 7** depicts electrochemical characterization of the films using ferro/ferricyanide 5mM at the different scan rates and methylene blue (MB) at the different concentrations of $NaBH_4$. The cathodic peak intensity has been made positive for graphical reasons.

**Figure 8** depicts substrate effect on the inkjet sintered films on Kapton for three situations: non-sintered (a), sintered with the sintering method using dipping (b), and sintered using inkjet printing with consumer printer (c).

**Figure 9** depicts the sheet resistance values for the 20 mm AuNPs-ink printed squares (in red) and resistance values of the 20 mm printed lines (in black) calculated and measured, after the 10 min treatment with different concentrations of $NaBH_4$ (a). The top right insets in the two plots show the layouts of the respective printed structures. Data are expressed as mean value $\pm$ standard deviation, (n = 3). Sheet resistance values for the 20 mm squares, after real-time inkjet sintering at increasing numbers of layers (b).

## Detailed Description of the Invention

Hereinafter, the present invention is described in more detail.

As described above, the sintering method is characterized in that sintering the nanoparticles and nano-structuration of the film is carried out in a single chemical reaction.

Firstly, the fact that sintering and nano-structuring are carried out in a single chemical reaction allows the method times to be considerably reduced and makes it easier for the method to be scaled up to an industrial level.

The reaction can be carried out in either an aqueous media or a solvent media. The reaction is suitable in a media including water, ethanol, methanol, isopropanol alcohol, ethylene glycol, pure or mixed or other solvents.

Advantageously, the sintering method of the fist aspect can be implemented to print patterns of metal nanoparticle conductive films using consumer printers.

The sintering method comprises the following steps:

- preparing a nanoparticle solution including from 1% to 40% in weight of metal nanoparticles caped with a capping agent, the metal nanoparticles comprising an average particle size from 2 nm to 50 nm, and depositing the nanoparticle solution on a substrate as a film;

- preparing a sintering solution including sodium borohydride as sintering agent in a concentration from 0.001 to 1 M, and optionally further including a stabilizing agent of the sodium borohydride in solution; and

- impregnating the metal nanoparticle film with the sintering solution, so the sintering solution contact the metal nanoparticle of the film to instantly initiate an exothermic chemical reaction at the interface of the nanoparticles that sinters the nanoparticles and nanostructures the film in a single chemical reaction.

In one embodiment, the metal nanoparticles films deposited in the first step are immersed into the sintering solution for 10 min for impregnating the deposited films, which resulted the time after which no relevant changes in the properties of the obtained nanostructured conductive metal nanoparticle films have been recorded. In fact, the reaction is almost instantaneous and up to 80% of the final film conductivity can be obtained simply impregnating by immersing and removing the film in the sintering solution. Preferably, immersing includes washing the film after the removal from the sintering solution.

The reaction is chemical and allows the simple and rapid fabrication of nanostructured conductive metals nanoparticles films on different substrates relying only on the special chemical properties of the starting materials.

The core of the invention relies on the collection of chemical energy at the junction between different nanoparticles, taking advantage of their catalytic activity, from a specific exothermic reaction, and using this energy to sinter the nanoparticles. Since the reaction strictly occurs at the nanoparticle interphase, it is rapid and effective. When all the active sites have reacted, the reaction stops. This creates a unique conductive network of nanoparticles, connected in a web structure which morphological properties can be finely tuned by the concentration of the reagents.

Advantageously, this happens avoiding the collapse of the pores in contrast with what normally occurs with chemical sintering methods of the art.

In another embodiment, the sintering method is carried out using a consumer printer. The consumer printer has multi-ink (color) cartridges connected to a single printhead with separated nozzle arrays can be used. The loading of the ink solution (nanoparticle solution) in a color channel, for example cyan, and of the sintering solution in a second one, for example yellow, allows for the implementation of sintering of the printed film in mixed color, for example, green. The film is impregnated with the desired amount of sintering solution to initiate the chemical reaction. The desired amount can be more than one layer of the sintering solution. In this embodiment, the preferable sodium borohydride concentration is >0.1 and up to 1M.

A conductive pattern is then obtained by means of a consumer printer.

Advantageously, a real-time sintering via inkjet printing can be performed with the sintering method defined in the first aspect of the present invention.

Unexpectedly, the sintering method in accordance with the first aspect of the present invention is also capable of modulating the kinetics of the catalytic reaction of said single chemical reaction. Thus, the sintering method of the first aspect solves a further drawback of the state of the art in connection with the porosity of the nanostructured conductive metal nanoparticle film.

The concept of creating a metal nanoparticle network which is both nanostructured and conductive is described herein for the first time, since the drawback for obtaining conductive films with the sintering methods in the art is the loss of the nanostructure and relying on to post treatments to the sintering eventually to then reobtain it. In the state of the art, the typically porous and not conductive nanostructures defined by the deposited nanoparticles is sacrificed to obtain a conductive and much less porous surface.

Nanoparticle solution

As described above, the nanoparticle solution is prepared comprising metal nanoparticles in a solution media.

Optionally, the nanoparticle solution can be prepared previously.

The nanoparticle solution comprises metal nanoparticles in a concentration from 1% to 40% in weight. The metal nanoparticles concentration can be as low as 1% and up to 40% in weight in accordance with the desired application of the film.

The metal nanoparticles can have an average particle size from 2 nm to 50 nm. Preferable average particle size is from 10 nm to 20 nm with a polydispersity index of about 0.18.

The single chemical reaction depends on the catalytic activity of the metal nanoparticles with the sodium borohydride. Therefore, metals without specific catalytic activity such as, for example, Ag do not lead to sintering and nanostructuring via the sintering method of the present invention.

Preferable metal nanoparticles are of a noble metal selected from the group consisting of Au and Pt, being the most used noble metals in electrochemistry as working electrodes materials.

Although other metals different from Au and Pt can be used, they must have catalytic activity with the sodium borohydride to sinter and nanostructure the film in accordance with the sintering method of the first aspect.

The metal nanoparticles are capped with a capping agent.

Preferable capping agent is polyvinylpyrrolidone (PVP), also commonly called polyvidone or povidone, that is a water-soluble polymer made from the monomer N-vinylpyrrolidone.

Thus, the nanoparticle solution comprises metal nanoparticles with a polymeric capping layer to stabilize the colloidal dispersion against aggregation in water-based solutions. The concentration of the capping agent affects the concentration of the reactants necessary for the reaction, the higher the concentration of the capping agent, the higher the concentration of the needed sintering agent, but the concentration of capping agent does not affect the obtained electrical, electrochemical, and structural properties.

Sintering solution

Optionally, the sintering solution can be prepared previously.

The sintering solution includes sodium borohydride as the unique sintering agent in a concentration from 0.001 M to 1M.

The authors of the present invention have found that the selection of an appropriate concentration subrange of the sintering agent $NaBH_4$ results in films that share surface morphology and conductivity properties.

Advantageously, the films reveal similar optical, electrical, and electrochemical properties in said concentration subranges, which allows finely tuning the surface morphology and conductivity properties of the films.

Table 1 below describes the concentration subranges as well as their effects on the optical, electrical, and electrochemical properties and how such concentration range influence on the film structure.

Table 1

| Concentration of $NaBH_4$ | Effect on the properties | Effect on the structure |
|---|---|---|
| 0.001 - 0.01 M | High SERS effect, low conductivity, low electrochemical properties | Low porosity, constant nanoparticle size |
| >0.01 - 0.1 M | Enhanced SERS effect, medium-high conductivity, medium-high electrochemical properties | Medium - high porosity, creation of the network of particles |
| >0.1 - 1 M | Low SERS effect, high conductivity, high electrochemical properties | High porosity, extended network of particles |

The sintering solution may further include a stabilizing agent of the sodium borohydride in solution. The stabilizing agent does not contribute to the chemical reaction but only stabilize the $NaBH_4$ in the solution to avoid spontaneous dissociation.

Preferable stabilizing agent is sodium hydroxide. The sodium hydroxide can be present in a concentration from 0 to 1M. The high NaOH concentration can be used to further stabilize the $NaBH_4$, thereby modifying the equilibrium of the dissociation reaction at high pH values.

$$NaBH_4 + 2H_2O \rightarrow NaBO_2 + 4H_2$$

$$NaBO_2 + 2H_2O \rightarrow NaOH + H_3BO_3$$

A low concentration of NaOH, for example, just 0.2% of NaOH in water solution, is enough to stabilize the $NaBH_4$ solution for several weeks without losing the significative amounts of $NaBH_4$ by spontaneous dissociation.

For consumer printers, it is preferable that the sintering solution includes NaOH.

The nanoparticle solution and/or the sintering solution may further include solvents such as ethylene glycol (EG), ethanol and isopropyl alcohol. Ethylene glycol (EG) can be added to the solution to increase the viscosity and ethanol and isopropanol act on the surface tension.

On the other hand, the authors of the present invention have found that the single chemical reaction is not particularly sensitive to temperature because it relies on the nano-chemical environment at junction between the nanoparticles.

Advantageously, the sintering method is capable of sintering and nano-structuring metal nanoparticle films using ambient/room temperatures.

The optimal performance of the sintering method is at temperatures from 4°C to 45°C, preferable from 10°C to 35°C. Temperatures higher than 45°C and up to 80°C can be work as well. However, at temperatures of 80°C and higher, the reaction is violent and damages the printed structures.

Therefore, the sintering method is suitable for any type of substrate, even substrates of low melting point temperature, such as those of a polymeric or paper nature, in particular PET, PEN, Kapton, normal paper, as long as they do not react with the sodium borohydride as sintering agent.

The fact that the sintering method can be performed at ambient/room temperature allows the metal nanoparticle film to be impregnated with the sintering solution by several techniques known in the art that include but are not limited to immersion (dipping), inkjet printing, drop casting, aerosol spraying, which are easily scalable and can be automated.

Advantageously, the time treatment of the $NaBH_4$ does not modify substantially the morphology properties of the nanostructured conductive metal nanoparticle film obtainable by the sintering method of the first aspect of the invention. This proves the suitability of the sintering method for on-line metal nanoparticle film inkjet printing using consumer printers.

As described above, in a second aspect, the object of the present invention is a nanostructured conductive metal nanoparticle film obtainable by the sintering method of the first aspect of the present invention.

Advantageously, the nanostructured conductive nanoparticle film of the second aspect is conductive and porous, and such properties can be finely modulated to the desired values.

An increase of the conductivity can be evaluated by means of a decrease of the sheet resistance and *vice versa*. The four-point probe method (44P) is widely known for the measurement of sheet resistivity, also known as surface resistivity.

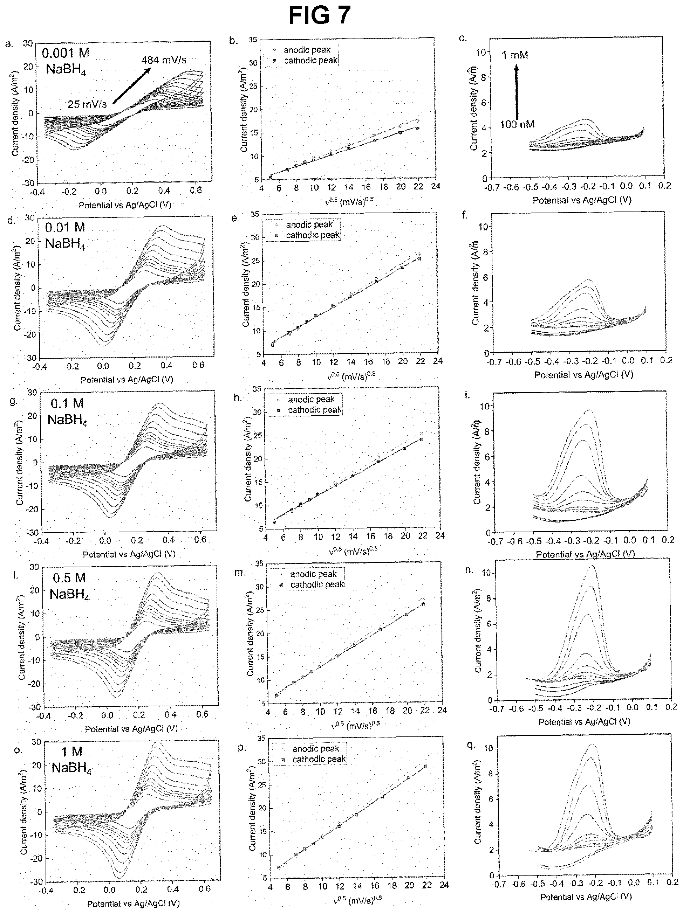

Table 2 below includes the values of the sheet resistance for the films at the different porosities and coefficient k0 for the electron transfer using a standard probe (ferro/ferricyanite redox couple) which is correlated to the efficiency of the redox reaction on the film surface, and in this case the porosity of the film, see Figure 7.

Table 2

|  | Sheet resistance ($\Omega$) (Conductivity property) | $k^0$ (cm s$^{-1}$) (Porosity-related property) |
|---|---|---|
| Low porosity-low conductivity | 22.1 $\pm$ 1.4 | 0.0014 |
| Medium porosity-medium conductivity | 8.5 $\pm$ 0.7 | 0.004 |
| High porosity-high conductivity | 1.5 $\pm$ 0.4 | 0.0076 |

The more porous the film the higher would be the efficiency of the reaction due to proximity effects and higher area of the film.

The electrical characterization of the nanostructured conductive nanoparticle film revealed a proportional decrease of the resistance with increasing concentrations of sodium borohydride within the range from 0.001M to 1M.

Furthermore, the nanostructure of the film varies with the concentration of sodium borohydride. It is theorized that this effect could be due to the necking process related to the sintering after the removal of the capping agent. The sintering method not only creates junctions between nanoparticles making the film conductive but also increases the porosity of the film in favor of a greater nano-structuration consequently increasing the surface-to-volume ratio.

As it will be demonstrated in the assays included in the example section, the morphological change of the surface with the $NaBH_4$ treatment at different concentrations is not attributable to the "oxidative variation" of the film but are attributable to changes in the nanostructure, mainly to the organization and nanoparticle shape changes.

The nano-structural change onto metal nanoparticles film can be finely tuned, thereby modulating the electrochemical properties and optical activity of the nanostructured conductive metal nanoparticle film.

Advantageously, the nanostructured conductive nanoparticle film has a homogenous net-like structure. The reason lays in the nature of the processes: on the one hand, the solid-state of the film and, on the other hand, the colloidal model. Unexpectedly, the modes of coalescence of the metal nanoparticles are able to change in accordance with the $NaBH_4$ concentration, and thereby it is assumed that this phenomenon is governed by two main driving forces: (i) spatial confinement and (ii) de-capping rate.

For high concentrations of sodium borohydride equal or higher than 0.1 M, the capping agent (PVP) destabilization rate is also high, the removal of the capping agent almost instantaneous, or in the range of seconds. The disposition of the metal nanoparticles in the film is governed by the printing and drying process, while during the sintering the metal nanoparticles start necking in all directions, toward the closest metal nanoparticles, creating a 3D porous network, given a large degree of freedom on the surface when the capping agent (PVP) is removed, and given a large amount of sintering agent and solution available. The situation is similar in the case of the sintering using a consumer inkjet printer, where the nanostructure changes after reaching a threshold value of layers (n=3) of sintering agent.

For low concentrations, or volumes (for sintering using a consumer inkjet printer), of sodium borohydride, lower than 0.1M, a slower destabilization of the capping agent layer is induced, resulting in no apparent change in the superficial nanostructure.

During the chemical sintering, there are no external sources of energy, the reaction is limited by the intrinsic chemical energy created during the sintering method, between sodium borohydride and capping agent, thus the network forming process stops when the thermodynamic equilibrium is reached. In other words, the process stops when the desorption/reabsorption of capping agent and the stability of the sintered metal nanoparticles reach balance. The dynamic equilibrium could explain why the nanoparticles do not change drastically their dimensions, forming grains and collapsing.

The mechanism of the de-capping might explain the peculiar modes of coalescence the metal nanoparticles undergo in this invention. It has been reported that PVP, as capping agent, has different binding modes on metal nanoparticles, depending on the size, length of the chain, and branching. Observing the broad size distribution of the metal nanoparticles used in the sintering method, it is reasonable to expect a contribution coming from the different binding modes of the polymer.

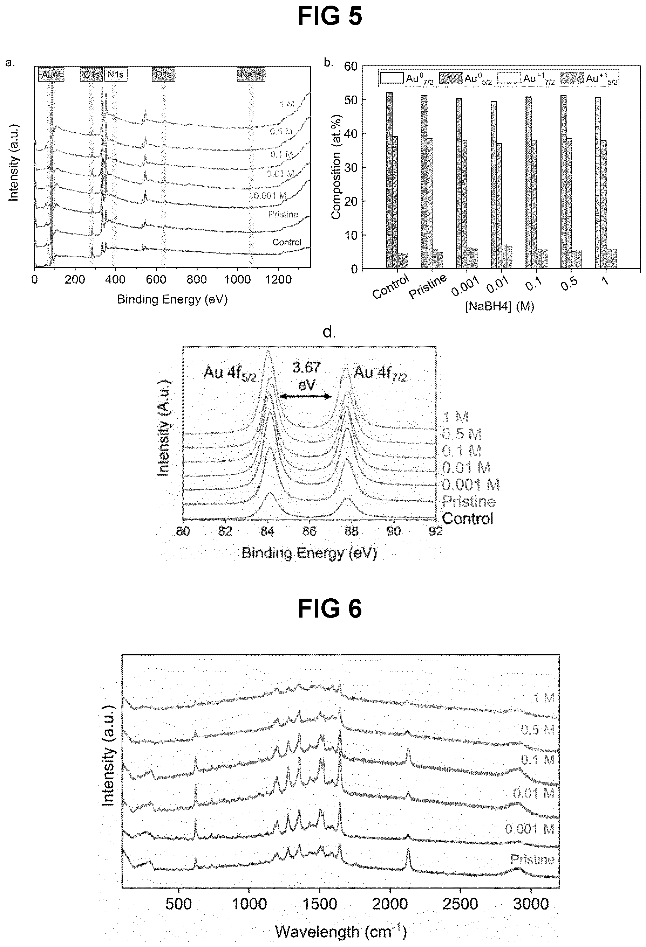

Assays using gold nanoparticles in the sintering method revealed that the absence of variation in the gold peak suggests that no relevant interaction between the nanoparticle's gold and the sodium borohydride takes place, with no change in the formal oxidative state of the gold coming from the treatment. In fact, the ratio between the components related to the Au (0) and the Au (I), does not change during the different concentrations of $NaBH_4$, and remains constant even after changes in concentration of several orders of magnitude, see Figure 5. To understand this phenomena, different interpretations have been theorized by the authors of the present invention: i) according to the already proposed mechanism from *Ansar et al,* it has been found that the substitution of the PVP as caping agent with hydride does not affect the gold oxidation state, and no change in the electronic shell of the Au can be detected; ii) the formal hydride species interacts directly with the polymer PVP, guided by the coordination of the polymer to the nanoparticle putting strains on the chemical amide bonds of the PVP. It is assumed that the mechanisms of de-capping take place at the same time. In both cases, the hydride formal species can react with water or the PVP creating hydrogen (bubbles form on the films when in contact with the $NaBH_4$), in an exothermic reaction which may be the source of energy inducing the coalescence. This energy, coming directly from the reaction, promotes the sintering. At the higher concentrations of $NaBH_4$ also modulates the nano-structuration, with distinctive electrochemical and optical proprieties, such as the color change caused by the change in the scattering properties of the material due to the neo-formed nanostructure.

In conclusion, it is provided an easy, implementable sintering method for metal nanoparticle solution able to tune the nanostructure of the films.

By the sintering method described herein it is then possible to fabricate and modulate nanofunctional structures in a direct and straightforward way.

A further aspect of the present invention is a device comprising a substrate coated with a nanostructured conductive metal nanoparticle film as defined above, which is characterized in that the nanostructured conductive metal nanoparticle film defines a conductive pattern on the substrate.

The substrate can be of any type of material as long as does not react with the sodium borohydride as sintering agent.

Advantageously, a substrate of polymer or paper materials is suitable for sintering using the method of the present invention due to that it is not hindered by the temperatures employed in the method for the reasons explained above.

Sheet resistance measurements have been performed and they confirmed the conductivity of the printed nanostructured metal nanoparticle films in the device.

Scanning electron microscopy have been performed and they confirmed the nano-porosity of the printed nanostructured metal nanoparticle films in the device.

The printed nanostructured metal nanoparticle films revealed a compact layer of nanoparticles sintered on the bottom, which gives the electrical macroscopic proprieties, and a disordered net-like structure on the top, giving the peculiar electrochemical proprieties at high sintering concentrations.

A further aspect of the present invention is the use of said nanostructured conductive metal nanoparticle film and/or said device comprising nanostructured conductive metal nanoparticle film and a substrate for electrical, electrochemical and/or photoelectrical applications.

The tuning of the nanostructure can be exploited for the waste-free, easy, and rapid fabrication of efficient electrochemical transducers or interfaces, fundamental in the fields of biosensing.

Particularly interesting are nanostructured Au and Pt films, which can be used for highly efficient and robust detection of organic and inorganic molecules like as heavy metals, small molecules, proteins, oligonucleotides, and even whole organisms such as virus and bacteria. Noble metals nanoparticles of Au and Pt are expensive compared to other metal nanoparticles, so cutting the expenses/materials waste related to all the fabrication steps of nanostructured devices represent a great economical advantage.

The tuning of the nanostructure can potentially be used to prevent the access to the interior of the material to the biggest molecules and interferents, or to increase the efficiency of the detection of a specific molecule by using aptamers as bioreceptors. Furthermore, the nanostructure is suitable for efficient gas sensing devices and sequestration/removal applications.

Moreover, other fields of interest can be fabrication of devices with enhances optical properties for Surface Enhanced Raman Spectroscopy (SERS), a fundamental technique used for photonic biosensors. In these applications, it is preferable tuning the nanostructure using lower concentrations of sodium borohydride and producing more ordered arrangement of the metal nanoparticles, which is known to cause an enhancement of this effect.

Finally, the integration of the sintering method in inkjet printers adding the reagent sodium borohydride in one or more of the available cartridges and the metal nanoparticle solution in the other ones, allows controlling and speeding up all the protocol, scaling-up and automating the sintering method of the present invention.

Therefore, the sintering method of the present invention can be provided as an all-in-one production system to fabricate the desired layout in the device and sinter it in real-time without any waste of time or materials.

Thus, the sintering method in accordance with the present invention has at least one of the following advantages:

- the sintering method relies on a unique chemical reaction on the nanoparticle interphase, which has the effect of inducing the sintering and at the same time the nano-structuration of the film;

- the sintering method provides a fast, easy, and scalable way to sinter and nano-structure metal nanoparticles films independently from the temperature, just by using the unique nature of the proposed chemical reaction and the starting materials;

- the sintering method can be performed at any ambient/room temperatures;

- the sintering method can be performed on low melting point substrates like as paper, plastic, etc., by using only standard and accessible chemical reagents.

**Examples**

Hereinafter, the present invention is described in more detail and specifically with reference to the Examples and Figures, which however are not intended to limit the present invention.

**Example 1**

*Nanoparticle ink - Nanoparticle solution*

The synthesis of nanoparticles can be carried out by any method known in the state of the art.
The following is just one way to do it.
Ultrapure, water-based gold nanoparticles were synthesized via pulsed laser ablation in liquids by RHP-Technology in a single-step approach enabling the synthesis of size-controlled and highly stable colloids at room temperature and atmospheric pressure. The laser system included an InnoSLab, nanosecond pulsed laser (IS400, Edgewave) delivering 7 ns full-half width maximum (FHWM) pulses at 1064 nm, at a repetition rate of maximum 10 kHz and pulse energy of 40 mJ. The laser beam was focused by a high-speed galvo scanner (intelliSCAN III-10, Scanlab) through a telecentric 65 mm focal length F-$\theta$ quartz lens (S4LFT4065/328, Sill Optics). Spherical shaped gold nanoparticles with a mean diameter size of 15$\pm$5 nm were generated from a 99.99% pure gold target (Agosi AG) in a closed flow chamber whereas the laser beam was coupled horizontally into the process chamber. As liquid media, 1 L Type I. water (>18 M$\Omega$ cm, Milli-Q, Merck-Millipore) containing 0.01 mM Polyvinylpyrrolidone (PVP10, Sigma Aldrich) was used while a controlled liquid flow of 500 mL/min was generated by a noncontact tube pump (Heidolph, Hei-FLOW Precision 06) circulating the liquid between a liquid reservoir and the ablation chamber. Upconcentration of the gold colloid into a high-stable nanoink was achieved by rotary evaporation (Hei-VAP Precision, Heidolph) (35°C, 35 mBar, 140 rpm) to remove the excess water and to adjust the NP concentration.
A water-based gold-ink with 26.5 w% solid particle content was thus obtained, that showed excellent long-term stability.
The nanoparticle ink formulation or nanoparticle solution was then adjusted to 15 w% AuNP concentration including 1.6 mM PVP capping agent in a printing solution composed of water (72%), ethylene glycol (25%), ethanol (2%) and isopropyl alcohol (1%).
In this example, the AuNPs had an average particle size of 15 nm with an index of polydispersity of 0.18.

*Device fabrication*

The printed patterns were designed in Autodesk AutoCAD 2020 and were composed of 2 connection pads (3 mm x 3 mm) and a 2 cm long 600 $\mu$m wide line connecting them.

**Example 2** *Sintering method by immersing*

The nanoparticle solution was as prepared in Example 1.
Several sintering solutions were prepared dissolving sodium borohydride to 0.001, 0.01, 0.1, 0.5 and 1M in 0.5% sodium hydroxide to stabilize the sintering agent and slow down the decomposition reaction.
Sodium borohydride powder (purity 98% and MW of 37.83 g/mol) and sodium hydroxide pellet (purity>98%, MW of 40.05 g/mol) were purchased from Sigma Aldrich. Ultrapure MilliQ Millipore deionized water (18.2 M$\Omega$/cm) was used for the preparation of the solutions.
The substrates used for printing were transparent polyethylene terephthalate (PET) A4 sheets with a porous coating to allow the immediate drying of the AuNPs water based ink and optimal adhesion (Mitsubishi Paper Mills NB-TP-3GU100).

The printed devices were immersed in each several sintering solutions in glass Petri dishes, right after the preparation. The sintering solution was left reacting under agitation for 10 min at room temperature. After that, the devices were removed and placed in a Milli-Q water bath twice, to stop the reaction and remove eventual side products. The washed devices are gently dried with a towel to remove the water excess and with nitrogen until completely dried.

**Example 3** *Inkjet Real-time Sintering method*

Implementation of the sintering method directly inside the inkjet printer was performed. Gold inkjet-printed lines were fabricated using an Epson XP15000 consumer printer.

In this example, all was implemented inside a small desktop inkjet printer to have compact equipment technically able to perform the fabrication of films and the sintering of the gold nanoparticles, inducing the nanostructure.

The sintering solution composition was modified to ensure the correct parameters for printability. The sintering solution was prepared by dissolving sodium borohydride in a solution containing 72% NaOH solution 0.5 M, ethylene glycol 21%, Ethanol 2%, and isopropyl alcohol 1%, to reach a final concentration of 0.5 M.

Kapton substrate was used since it does not have the permeable coating typical of the commercial Mitsubishi sheets, the solution can stain over the film more time reacting with the gold nanoparticles. Kapton sheets were purchased from DuPont. The printing was performed on A5 sheets treated with NaOH 4M increase the surface wettability.

Consumer printers have multi-ink (color) cartridges connected to a single printhead with separated nozzle arrays.

6 ml of the ink solution prepared in Example 1 was poured into an empty cartridge (supplier) already installed on the printer printhead (cyan channel). The loading of the AuNPs solution in a color channel (e.g. cyan) and of the sintering agent in a second one (e.g. yellow) allows for the implementation of sintering of the printed AuNPs by printing the desired designs in mixed colors (e.g. green).

The sintering solution was prepared by dissolving sodium borohydride in a solution containing 72% NaOH solution 0.5 M, ethylene glycol 21%, Ethanol 2%, and isopropyl alcohol 1%, to reach a final concentration of 0.5 M.

The sintering solution was loaded inside the cartridge and placed in the yellow channel performing multiple prints on the gold films, drying after the printing, and performing the washing only at the end of the desired amount of deposition. This is been done for two reasons: first to increase the local concentration of the agent before, and second to mimic the situation of a real-time printing and sintering where the sheets undergo multiple passes before being washed or used. The gold films, for sake of simplicity, were cut and attached to a paper sheet to be placed inside the printer.

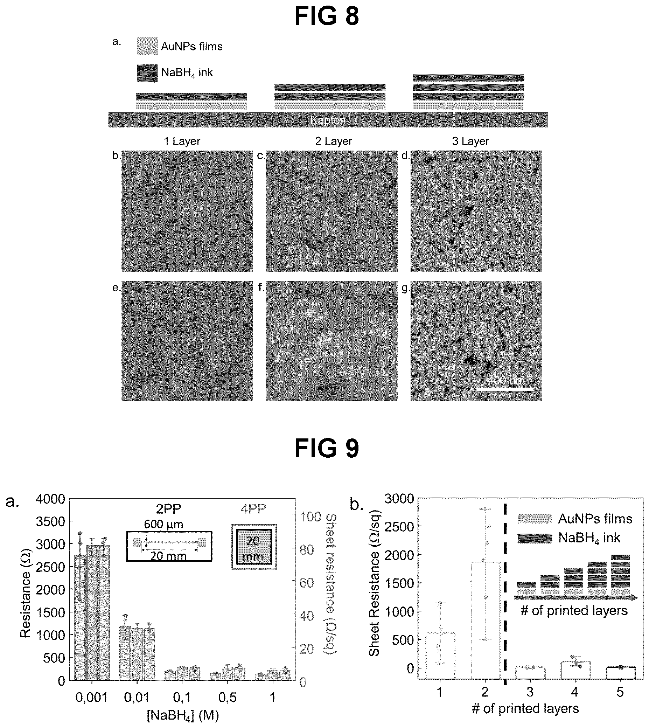

The morphology was investigated using HR-SEM showing an evident change in the nanostructure after printing 3 layers of sintering solution, see Figure 8 and Figure 9.

The nanoparticles form the network of connection once the threshold concentration is reached. There is a critical value to reach and start to have a clear change in the electrical and morphological proprieties, previously the concentration, in this case, the number of prints, which is related to the volume of solution deposited.

*Surface characterizations*

Pictures of the printed lines were acquired by an Andostar ADSM302 optical microscope, keeping the same focus and brightness during the whole study.

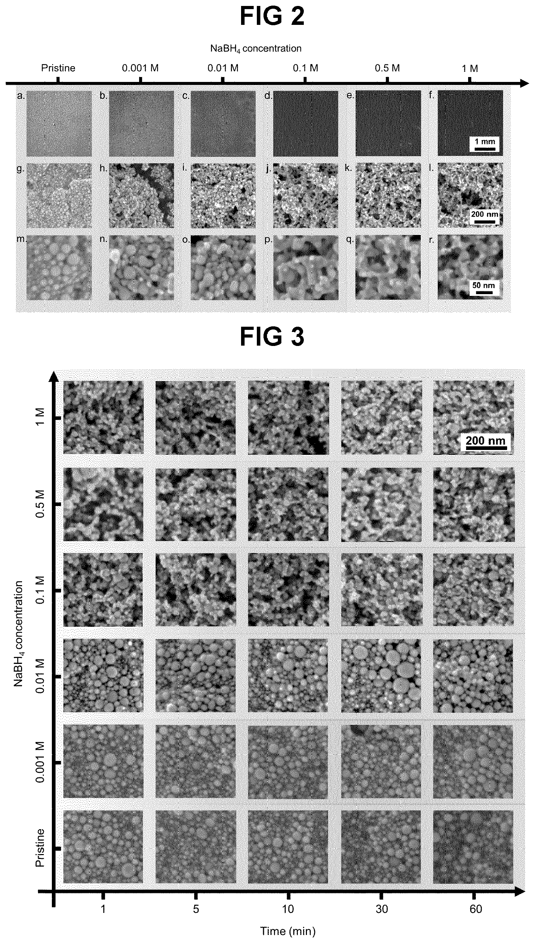

SEM analysis was performed by an XHRSEM Magellan 400L Thermo Fisher Scientific microscope. The images were collected operating in a high vacuum with an electron beam energy of 2 kV and secondary electrons in-lens detector. See Figures 2 and 3.

Figure 2 as well as Figure 3 both reveal that 0.1 M is the threshold $NaBH_4$ concentration for triggering an extended nanostructure change. Conversely, time in this timeframe does not appear to have an evident effect on the morphology.

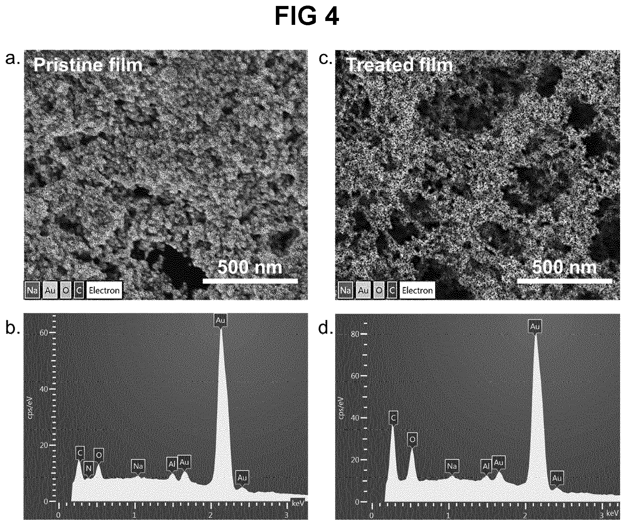

From a macroscopic point of view, the treatment produced an unexpected change in the color of the gold nanoparticle film, with a variation from a gold color to deep brown, proportionally to the $NaBH_4$ concentration, see Figure 2 (a-f). Therefore, the pristine, untreated and nonconductive, and the sintered conductive AuNPs-films obtained by the treatment performed with different $NaBH_4$ concentrations have been subjected to physicochemical characterization, to determine the nature of this change. The morphological change of the surface with the treatment could explain the color variation of the films, because of different light absorbance. To verify this hypothesis, compositional alterations of the surface were analyzed with EDX (Figure 4) and XPS (Figure 5).

The chemical and compositional analysis was performed using standard methods like XPS and EDX, to have information about the surface level and the more depth levels of the films. Boron, was not detected, even when high concentrations of $NaBH_4$ were used. The accumulation of the by-product of the reaction appears to not occur. The metaborate is soluble and can be eliminated during the reaction time, done agitating and the sequent washing steps. It is also worth considering that these nanoparticles are negatively charged on the surface (Zeta Potential measurements) with a formal ZP of -42 eV in water solution so electrostatic repulsion is likely to contribute.

An energy-dispersive X-ray spectroscopy (EDX mapping) was performed right after taking the pictures increasing the energy to 6 kV and looking for gold, carbon, oxygen, nitrogen, and sodium elements, see Figure 4.

An X-ray photoelectron spectroscopy (XPS) analysis was performed at room temperature by a SPECS PHOIBOS 150 hemispherical analyzer (SPECS GmbH, Berlin, Germany) with a base pressure of $5 \times 10^{-10}$ mbar using monochromatic A1 K alpha radiation (1,486.74 eV) as excitation source, with a power of 300 W. The energy resolution was 0.62 eV, as measured by the full width at half maximum (FWHM) of the Ag $3d_{5/2}$ peak for sputtered silver foil. The spectra were calibrated using C 1s at 284.8 eV as reference. The data analysis and fitting were performed using CasaXPS software. The constructed peak model was defined by using a Voigt function, with a Shirley background for the Au 4f. The ratio between the areas of the two 4f orbitals in the gold was fixed as a constraint considering the degeneration of the two orbitals, see Figure 5 (a-b). No other additional constraints were used to allow the model to fit the data realistically and in a meaningful fashion.

The high-resolution XPS spectra of the Au 4f, see Figure 5 (c), show the doublets corresponding to the photoemission peaks of the $4f_{5/2}$ and $4f_{7/2}$ orbitals, at binding energies of 87.79 eV and 84.12 eV, respectively with a peak-to-peak distance of 3.67 eV. The data is coherent with the nanoparticles being in the metallic form with formal oxidation state Au(0). Both the distance and the position of the peaks remain constant with the treatment. The peak intensities change accordingly to the extent of the removal when the concentration of $NaBH_4$ is increased. These data prove that the color changes of the films are not attributable to the 'oxidative variation' of the film, but are attributable to changes in the nanostructure.

To shed further light on the differences in nanostructure Enhanced Scattering Raman Spectroscopy (SERS) was used to characterize the morphological differences of the films subjected to different sintering treatments; Rhodamine was used as a probe, and the intensity of its characteristic peak (1626 cm$^{-1}$) taken as signal. The Rhodamine signal increased until a maximum value for the films treated with 0.01M $NaBH_4$, then decreases further increasing the sintering agent concentration. Numerous factors influence the SERS phenomena, such as the nature and the morphology of the metal on the substrate; among others, particularly significant is the organization and nanoparticles shape, see Figure 6. As observable in the SEM images (Figure 2), the 0.01M treated substrate same to have the more favorable compromise between AuNPs morphology and distance.

*Electrochemical characterizations*

For all the electrochemical measurements, one connection pad has served as contact and the other as a working electrode. A reproducible working electrode area has been obtained insulating the AuNPs connection line (between the two pads) with screen printing insulating paste. The three-electrode electrochemical cell was completed with an external standard reference (Ag/AgCl 3M KCl) and counter (platinum wire) electrodes. The electrochemical characterizations have been performed using a PalmSens4 potentiostat. CVs were performed in 5 mM ferro/ferricyanide in PBS, scanning the potential from -0.35 to 0.65 V with scan rates of 25, 49, 64, 81, 100, 144, 196, 289, 400, 484 mV/s. The recorded spectra in $H_2SO_4$ 0.5 M were done with a scan rate of 100 mV/s using a scanning potential from -0.35 to 1.55 V. The cleaning in sulfuric acid has been performed using a scanning potential from -0.35 to 1.55 V, with a scan rate of 200 mV/s, performing 15 complete scans.

Square wave voltammetry (SWV) was used to obtain the MB calibration curve for the treated devices. SWV parameters used: equilibration time 10 s at 0.1 V, frequency 25 Hz, amplitude 25 mV, potential ranging from 0.1 to -0.5 V vs Ag/AgCl (reduction peak of the methylene blue), E step of 0.003 mV. The concentration of methylene blue (MB) ranged from 100 nM to 1 mM.

Figure 7 shows the results for the CVs and SWV at the different concentrations of the $NaBH_4$. The response varies linearly with the concentration, and this is reflected by observing the slope of the curve in the central column: the higher the concentration, the higher the slope of the linear fit. For the SWV instead, the peak height is the reference value to evaluate, related to the response that the film has to a specific concentration of an electroactive species. The results of the two-technique are coherent, even though they were performed on different batches of printed gold, showing reproducibility and reliability of the morphological effect on the electrochemical proprieties. From the CVs, specifically, the peak maximum and square root of the scan rate is possible to calculate, using the Randall-Sevick equation, a value of the electroactive area of the gold film. Important to understand that this is not a value of porosity, nor should be taken as such: is a value of the amount of material on the surface involved during the redox process. Nonetheless is a useful index of the effectiveness of the treatment and measures the electron transfer constant k0, a value of the efficiency of the redox process.

Table 2 above includes the values of the sheet resistance for the films at the different porosities and coefficient k0 for the electron transfer, see also Figure 7.

The values of the area increase with the concentration of $NaBH_4$ as well as the electron transfer constant k0. The increase of the electron transfer constant is coherent with what was expected. The porosity and morphology change induced by the treatment, creating the net-like structure, creates wells and cavities, where the redox reaction happens at a faster rate, due to a sum of different phenomena.

*Electrical resistance*

The electrical resistance of the AuNPs films printed lines was measured by a Keithley DMM6500 multimeter with standard probes, simply touching the pads at the two extremes of each line.

The four-point probe method (44P) is widely known for the measurement of sheet resistivity, also known as surface resistivity. The general method consists of performing a 4-wire measurement in some conditions. A requirement is that the 4 probes must be equidistant. Another requirement is that the thickness of the film is less than 0.4 of the separation between the probes. Finally, the probes must be centered in the area to be measured. A geometric correction C is necessary to apply when the ratio between the side of the square (W) and the separation between probes (S) is less than 40. Haldor Topsoe, in Geometric Factors in Four Point Resistivity Measurement (1966), provides a table where the correction factor is indicated, with which it is possible to interpolate.

The sheet resistivity $R_{sq}$ can be calculated by the following equation:

$$R_{sq} = \frac{\pi}{\ln(2)} \cdot C \cdot \left(\frac{\Delta V}{I}\right) = 4\left(\frac{\Delta V}{I}\right)$$

wherein ($\Delta V/I$) is the value reported by a multimeter and C is the correction factor.

Likewise, there is an excellent correlation between the sheet resistance measurements and the 2-wire measurements made on the simple traces as seen in Figure 9 (a). The central bar is the sheet resistance multiplied by the aspect ratio of the trace, that is, 33.33 squares, which corresponds to dividing the length of the trace by its width. Finally, the bar on the left is the resistance measured with the 2-wire method. It can be seen that when the area is smaller, particularly for fine traces, chemical sintering is more effective, this result in a lower resistance value, especially in high $NaBH_4$ concentrations. Additionally, the traces sintered at a high concentration of $NaBH_4$, show less standard deviation.

Regardless of the type of measurement, a decrease in resistance to increasing concentration of $NaBH_4$ is evidenced up to 0.1 M. Figure 9 (b) shows the resistivity obtained for the real-time sintering, performed by placing the $NaBH_4$ solution in a dedicated cartridge of the printer. In this case, 0.5 M $NaBH_4$ was used and different passages (named layers) with the printer have been performed onto the ink-jet printed gold film. Since the two methods to measure the sheet resistance returned complementary results, for this test only four-point probe measures were performed. There is a minimum amount of $NaBH_4$ layers required to obtain the sintering. Up to two $NaBH_4$ layers, the sintering is scarce and not reproducible, indicating a not complete and heterogeneous treatment. Starting from 3 layers of $NaBH_4$, a complete and reproducible sintering was obtained; this is evidenced by the sharp decrease in resistivity and the low standard deviation. Noteworthy, the resistivity obtained with the real-time treatment result like the ones obtained off-line.

**Claims**

1. A sintering method for obtaining a nanostructured conductive metal nanoparticle film, **characterized in that** the method includes sintering the metal nanoparticles and nano-structuring the film in a single chemical reaction.

2. The method of claim 1, the method comprising the steps of:

   - preparing a nanoparticle solution including from 1% to 40% in weight of metal nanoparticles caped with a capping agent, the metal nanoparticles having an average particle size from 2 nm to 50 nm, and depositing the nanoparticle solution on a substrate as a film;
   - preparing a sintering solution including sodium borohydride as sintering agent in a concentration from 0.001 to 1 M, and optionally further including a stabilizing agent of the sodium borohydride in solution; and
   - impregnating the metal nanoparticle film with the sintering solution, so the sintering solution contact the metal nanoparticle of the film to instantly initiate an exothermic chemical reaction at the interface of the nanoparticles that sinters the nanoparticles and nanostructures the film in a single chemical reaction.

3. The method of claim 2, wherein the sintering solution further includes sodium hydroxide as stabilizing agent.

4. The method of any one of previous claims, wherein the metal nanoparticles are of a noble metal selected from the group consisting of Au and Pt.

5. The method of any one of previous claims, wherein the metal nanoparticles have an average particle size from 10 nm to 20 nm and a polydispersity index of about 0.18.

6. The method of any one of previous claims, wherein the chemical reaction is carried out at a desired value of room temperature ranging from 4°C to 45°C.

7. The method of any one of previous claims which is implemented in a consumer printer.

8. A nanostructured conductive metal nanoparticle film **obtainable** by the method defined in claims 1 to 7.

9. The nanostructured conductive nanoparticle film of claim 8, wherein the metal nanoparticles are connected between them forming a conductive network structure with extended nano-structuration inside the film.

10. The nanostructured conductive nanoparticle film of claims 8-9, wherein the film is porous.

11. A device comprising a nanostructured conductive nanoparticle film defined in claims 8 to 10 on a substrate, **characterized in that** the nanostructured conductive nanoparticle film defines a conductive pattern on the substrate.

12. The device of claim 11, wherein the substrate is of polymeric or paper nature.

13. The device of any one of claims 10-12, wherein the device is an electrode.

14. The device of any one of claims 10-12, wherein the device is a biosensor.

15. Use of a nanostructured conductive metal nanoparticle film defined in any one of claims 8 to 10 for electrical, electrochemical and/or photonic applications.

# FIG 1

a. AuNPs cartridge fill | Printing | NaBH$_4$ treatment | Devices ready for use

b. PVP

AuNP

c. AuNPs ink | NaBH$_4$

Cartridge 1 | Cartridge 2

Piezo-electric printhead

Nozzle 1 | Advancement direction | Nozzle 2

Solvent evaporation

Substrate

# FIG 2

# FIG 3

# FIG 4

# FIG 5

# FIG 6

# FIG 7

# FIG 8

a.
AuNPs films

NaBH$_4$ ink

Kapton

1 Layer      2 Layer      3 Layer

b.    c.    d.

e.    f.    g.

400 nm

# FIG 9

a.

2PP     4PP

600 μm

20 mm

20 mm

[NaBH$_4$] (M)

Resistance (Ω)

Sheet resistance (Ω/sq)

b.

AuNPs films

NaBH$_4$ ink

# of printed layers

Sheet Resistance (Ω/sq)

# of printed layers

**Europäisches Patentamt**
**European Patent Office**
**Office européen des brevets**

# EUROPEAN SEARCH REPORT

Application Number

EP 23 38 2677

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 110 461 101 A (UNIV TSINGHUA) 15 November 2019 (2019-11-15) | 1-3,5,6, 8-15 | INV.<br>B22F1/0545 |
| A | * abstract * <br> * example 2 * | 4,7 | B22F1/102<br>B22F3/23<br>C22C1/04 |
| X | KR 101 481 629 B1 (AMOGREENTECH CO LTD [KR]) 16 January 2015 (2015-01-16) | 1-4, 8-11,13, 15 | C09D11/52<br>C09D11/54<br>H05K1/09 |
| A | * claims 1, 8 * <br> * paragraph [0039] * | 5-7,12, 14 | H05K3/12<br>B22F7/04 |
| X | US 2022/010160 A1 (ZHONG CHUAN-JIAN [US] ET AL) 13 January 2022 (2022-01-13) | 1,4-15 | |
| A | * example 3 * <br> * paragraphs [0392], [0500] * | 2,3 | |
| X | US 2012/168684 A1 (MAGDASSI SHLOMO [IL] ET AL) 5 July 2012 (2012-07-05) | 1,4-13, 15 | |
| A | * paragraph [0056] – paragraph [0058] * <br> * paragraphs [0061], [0066], [0072] * <br> * paragraph [0094] * <br> * example 1 * | 2,3,14 | TECHNICAL FIELDS SEARCHED (IPC) |
| X | ZHUANG HUI ET AL: "Chemical sintering of direct-written silver nanowire flexible electrodes under room temperature", NANOTECHNOLOGY, INSTITUTE OF PHYSICS PUBLISHING, BRISTOL, GB, vol. 28, no. 28, 23 June 2017 (2017-06-23) , page 285703, XP020317724, ISSN: 0957-4484, DOI: 10.1088/1361-6528/AA76CE [retrieved on 2017-06-23] | 1,6, 8-13,15 | B22F<br>C22C<br>C09D<br>H05K |
| A | * 2.3 Direct-writing of Ag NW electrodes and low temperature sintering * | 2-5,7,14 | |

-/--

The present search report has been drawn up for all claims

| Place of search | Date of completion of the search | Examiner |
|---|---|---|
| The Hague | 1 December 2023 | Fodor, Anna |

EPO FORM 1503 03.82 (P04C01)

Europäisches
Patentamt

European
Patent Office

Office européen
des brevets

# EUROPEAN SEARCH REPORT

**Application Number**

EP 23 38 2677

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| T | RENLIANG XU ET AL: "Comparison of sizing small particles using different technologies", POWDER TECHNOLOGY, ELSEVIER, BASEL (CH), vol. 132, no. 2-3, 24 June 2003 (2003-06-24), pages 145-153, XP002711749, ISSN: 0032-5910, DOI: 10.1016/S0032-5910(03)00048-2 * figure 1 * * tables 3, 6 * | 1-15 | |
| | | | **TECHNICAL FIELDS SEARCHED (IPC)** |

The present search report has been drawn up for all claims

| Place of search | Date of completion of the search | Examiner |
|---|---|---|
| The Hague | 1 December 2023 | Fodor, Anna |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 38 2677

This annex lists the patent family members relating to the patent documents cited in the above-mentioned European search report.
The members are as contained in the European Patent Office EDP file on
The European Patent Office is in no way liable for these particulars which are merely given for the purpose of information.

01-12-2023

| Patent document cited in search report | | Publication date | Patent family member(s) | | Publication date |
|---|---|---|---|---|---|
| CN 110461101 | A | 15-11-2019 | NONE | | |
| KR 101481629 | B1 | 16-01-2015 | NONE | | |
| US 2022010160 | A1 | 13-01-2022 | NONE | | |
| US 2012168684 | A1 | 05-07-2012 | CN | 102686777 A | 19-09-2012 |
| | | | EP | 2411560 A1 | 01-02-2012 |
| | | | JP | 2012521493 A | 13-09-2012 |
| | | | KR | 20130010101 A | 25-01-2013 |
| | | | US | 2012168684 A1 | 05-07-2012 |
| | | | WO | 2010109465 A1 | 30-09-2010 |

EPO FORM P0459

For more details about this annex : see Official Journal of the European Patent Office, No. 12/82

**REFERENCES CITED IN THE DESCRIPTION**

**Patent documents cited in the description**

- WO 2022157725 A

- KR 101481629

**Non-patent literature cited in the description**

- **HALDOR TOPSOE**. *Geometric Factors in Four Point Resistivity Measurement*, 1966